# EUROPEAN PATENT APPLICATION

(11) **EP 1 878 767 A1**
(43) Date of publication of application: **16.01.2008**
(21) Application number: 07252752.6
(22) Date of filing: 10.07.2007
(51) Int. Cl.: C08L 83/04, H01L 23/373, C09K 5/08, C08K 3/02, C08K 3/04, C08K 3/08, C08K 3/22, C08K 3/28, C08K 3/38, C08K 5/5419, C08K 7/06

(54) **Heat conductive silicone grease composition and cured product thereof**

(30) Priority: 12.07.2006 JP 2006191835
(71) Applicant: Shin-Etsu Chemical Co., Ltd., Tokyo (JP)
(72) Inventor: Endo, Akihiro c/o Shin-Etsu Chemical Co., Ltd., Annaka-shi, Gunma-ken (JP); Miyoshi, Kei c/o Shin-Etsu Chemical Co., Ltd., Annaka-shi, Gunma-ken (JP); Yamada, Kunihiro c/o Shin-Etsu Chemical Co., Ltd., Annaka-shi, Gunma-ken (JP)
(74) Representative: Hallybone, Huw George

(57) **Abstract**

Provided is a heat conductive silicone grease composition, including: an organopolysiloxane containing 2 or more alkenyl groups bonded to silicon atoms within each molecule, an organopolysiloxane with a specific structure and with a kinematic viscosity at 25°C of 10 to 10,000 mm²/s, an alkoxysilane containing specific substituent groups, an organohydrogenpolysiloxane containing 2 or more SiH groups within each molecule, a heat conductive filler, a platinum-based catalyst, and an addition reaction retarder. The heat conductive silicone grease composition exhibits high thermal conductivity, has excellent fluidity prior to curing and therefore exhibits favorable workability, is capable of filling fine indentations and therefore reduces contact resistance, and is also able to prevent oil separation and bleeding of the heat conductive material following curing, meaning the composition exhibits excellent heat radiation performance and reliability. Also, the heat conductive silicone grease composition exhibits improved durability under conditions of high temperature and high humidity, and thereby exhibits further improved reliability during actual use.

## Description

### BACKGROUND OF THE INVENTION

### 1. Field of the Invention

The present invention relates to a heat conductive silicone grease composition which, even when filled with a large quantity of a heat conductive filler in order to provide superior thermal conductivity, still retains favorable fluidity and favorable handling properties, and also exhibits excellent durability and reliability under conditions of high temperature and high humidity. The invention also relates to a method of curing such a composition, a cured product of the composition, an electronic device comprising such a cured product, and a method of forming a heat conductive member between an electronic component and a heat-radiating member.

### 2. Description of the Prior Art

Electronic components mounted on printed wiring boards, including IC packages such as CPUs, can suffer from deterioration in the component performance or even failure of the component as a result of temperature increases caused by heat generated during operation of the component. Accordingly, a heat conductive sheet with good thermal conductivity or a heat conductive grease is conventionally sandwiched between the IC package and a heat-radiating member with heat-radiating fins, thereby efficiently conducting the heat generated by the IC package or the like through to the heat-radiating member, which then radiates the heat away. However, as the performance of electronic components improves, the quantity of heat generated by the components also tends to increase, meaning there is a demand for the development of materials and members with even better thermal conductivity than conventional materials.

Numerous methods have been proposed for efficiently removing this heat. Particularly in the case of electronic components that generate large quantities of heat, methods have been proposed in which the heat is dissipated by placing a heat conductive material such as a heat conductive grease or heat conductive sheet between the electronic component and another member such as a heat sink (see patent reference 1 and patent reference 2).

Heat conductive sheets offer workability advantages as they can be easily mounted and installed. However, even if the surface of a CPU or heat-radiating fin or the like appears smooth, it actually includes microscopic irregularities. As a result, a heat conductive sheet cannot actually be bonded completely reliably to the surface, and an air layer develops between the sheet and the surface, causing a deterioration in the heat-radiating effect. In order to overcome this problem, a method has been proposed in which a pressure-sensitive adhesive layer or the like is provided on the surface of the heat conductive sheet to improve the adhesion, but the resulting heat-radiating effect is still unsatisfactory.

Known examples of more effective heat conductive materials include heat-radiating greases that comprise a zinc oxide or alumina powder blended into a silicone oil base (see patent reference 3 and patent reference 4).

Moreover, in order to further improve the thermal conductivity, heat conductive materials that use aluminum nitride powder are also known. The patent reference 1 discloses a thixotropic heat conductive material that comprises a liquid organosilicone carrier, silica fiber, and one or more materials selected from amongst dendritic zinc oxide, lamellar aluminum nitride and lamellar boron nitride. Patent reference 5 discloses a silicone grease composition obtained by blending a spherical hexagonal aluminum nitride powder with a specified particle size range into a specific organopolysiloxane. Patent reference 6 discloses a heat conductive silicone grease that uses a combination of a fine aluminum nitride powder with a small particle size and a coarse aluminum nitride powder with a large particle size. Patent reference 7 discloses a heat conductive silicone grease that uses a combination of an aluminum nitride powder and a zinc oxide powder. Patent reference 8 discloses a heat conductive grease composition that uses an aluminum nitride powder that has been surface-treated with an organosilane.

Aluminum nitride has a thermal conductivity of 70 to 270 W/(m·K), whereas diamond has an even higher thermal conductivity of 900 to 2,000 W/(m·K). Patent reference 9 discloses a heat conductive silicone composition that comprises a silicone resin, diamond, zinc oxide, and a dispersant.

Furthermore, metals also have a high thermal conductivity, and can be used in those situations where insulation of the electronic component is unnecessary. Patent reference 10 discloses a heat conductive grease composition obtained by mixing metallic aluminum powder with a base oil such as a silicone oil.

Heat conductive greases offer other advantages in that they are unaffected by irregularities in the surfaces of the IC package such as a CPU or the heat-radiating member, and conform to, and follow these irregularities, meaning the IC package and the heat-radiating member can be held together without any intervening gaps, thus ensuring a small interfacial thermal resistance. However, these greases suffer from oil bleeding problems when used over extended periods. For these reasons, methods have been proposed that use liquid silicone rubber compositions as potting agents or adhesives (see patent reference 11 and patent reference 12).

However, none of these heat conductive materials or heat conductive greases is able to satisfactorily cope with the quantity of heat generated by modem integrated circuit elements such as CPUs.

Heat conductive sheets and heat conductive greases both require the addition of a heat conductive filler in order to achieve thermal conductivity. However, the apparent viscosity of either material must be restricted to a certain upper limit. In the case of a heat conductive sheet, this restriction is necessary to prevent any obstacles to workability or processability within the production process, whereas in the case of a heat conductive grease, the restriction is necessary to prevent any workability problems during application of the grease by syringe to an electronic component. As a result, there is a limit to how much heat conductive filler can be added to either material, meaning satisfactory thermal conductivity cannot be achieved.

It is known from the theoretical equation of Maxwell and Bruggeman that the thermal conductivity of a material obtained by blending a heat conductive filler into a silicone oil is substantially independent of the thermal conductivity of the heat conductive filler if the volume fraction of the heat conductive filler is 0.6 or less. The thermal conductivity of the material only starts to be affected by the thermal conductivity of the heat conductive filler once the volume fraction of the filler exceeds 0.6. In other words, in order to raise the thermal conductivity of a heat conductive grease, the first important factor is to determine how to enable the grease to be filled with a large quantity of heat conductive filler. If such high-quantity filling is possible, then the next important factor is to determine how to enable the use of a filler with a high thermal conductivity. However, high-quantity filling causes a variety of problems, including a reduction in the fluidity of the heat conductive grease, and a deterioration in the workability of the grease, including the coating characteristics (such as the dispensing and screen printing characteristics), making practical application of the grease impossible. In addition, because the fluidity of the grease decreases, the grease becomes unable to fill minor indentations within the surface of the electronic component and/or heat sink, which causes an undesirable increase in the contact resistance.

With the aim of producing heat conductive materials with high-quantity filling and favorable fluidity, investigations have also been conducted into adding an alkoxy group-containing organopolysiloxane that treats the surface of the heat conductive filler, thereby causing a significant improvement in the dispersibility of the filler (see patent reference 13 and patent reference 14). However, these treatment agents degenerate via hydrolysis or the like under conditions of high temperature and high humidity, causing a deterioration in the performance of the heat conductive material. Furthermore, although these heat conductive materials exhibit favorable fluidity, as described above, they tend to suffer from oil bleeding problems when used over extended periods.
[Patent Reference 1] EP 0 024 498 A1
[Patent Reference 2] JP 61-157587 A
[Patent Reference 3] JP 52-33272 B
[Patent Reference 4] GB 1 480 931 A
[Patent Reference 5] JP 2-153995 A
[Patent Reference 6] EP 0 382 188 A1
[Patent Reference 7] USP 5,981,641
[Patent Reference 8] USP 6,136,758
[Patent Reference 9] JP 2002-30217 A
[Patent Reference 10] US 2002/0018885 A1
[Patent Reference 11] JP 61-157569 A
[Patent Reference 12] JP 8-208993 A
[Patent Reference 13] US 2006/0135687 A1
[Patent Reference 14] JP 2005-162975 A

### SUMMARY OF THE INVENTION

In light of the conventional technology described above, the main object of the present invention is to provide a heat conductive silicone grease composition that exhibits high thermal conductivity, has excellent fluidity prior to curing and therefore exhibits favorable workability, and is capable of filling fine indentations, thereby reducing contact resistance. In addition, another object of the present invention is to provide a heat conductive silicone grease composition which exhibits excellent heat radiation performance and reliability as a result of preventing oil separation and bleeding of the heat conductive material following curing. In addition, another object of the present invention is to improve the durability, under conditions of high temperature and high humidity, of this heat conductive silicone grease composition that exhibits excellent workability, heat radiation performance and reliability, thereby further improving the reliability of the composition during actual use.

The inventors of the present invention discovered that a heat conductive silicone grease composition comprising an organopolysiloxane containing 2 or more alkenyl groups bonded to silicon atoms within each molecule, an organopolysiloxane with a specific structure and with a kinematic viscosity at 25°C of 10 to 10,000 mm²/s, an alkoxysilane containing specific substituent groups, an organohydrogenpolysiloxane containing 2 or more hydrogen atoms bonded to silicon atoms within each molecule, a heat conductive filler, a platinum-based catalyst, and an addition reaction retarder exhibits excellent thermal conductivity, displays excellent fluidity prior to curing and therefore exhibits favorable workability and a favorable heat-radiating effect, and is also able to prevent oil separation and bleeding of the heat conductive material following curing, meaning the composition exhibits excellent reliability. They also discovered that a cured product of this composition exhibits extremely superior durability under conditions of high temperature and high humidity. The inventors found that by sandwiching a layer of a cured product of the composition of the present invention between an electronic component and a heat-radiating member, the cured product could be used as a heat conductive member with low thermal resistance, and that the heat generated during operation of the electronic component could be conducted rapidly through this heat conductive member and into the heat-radiating member, thus providing an electronic device such as a semiconductor device with excellent heat radiation properties. Based on these discoveries, the inventors were able to complete the present invention.

In other words, a first aspect of the present invention provides a heat conductive silicone grease composition, comprising:
(A) 100 parts by volume of an organopolysiloxane containing 2 or more alkenyl groups bonded to silicon atoms within each molecule,
(B) 0.1 to 300 parts by volume of an organopolysiloxane with a kinematic viscosity at 25°C within a range from 10 to 10,000 mm²/s, represented by a general formula (1) shown below: 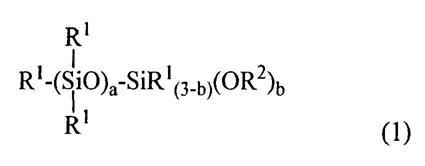 (wherein, R¹ represents identical or different, unsubstituted or substituted monovalent hydrocarbon groups, each R² represents, independently, an alkyl group, alkoxyalkyl group, alkenyl group or acyl group, a represents an integer from 5 to 100, and b represents an integer from 1 to 3),
(C) 0.1 to 50 parts by volume of an alkoxysilane represented by a general formula (2) shown below:

   R³_{c}R⁴_{d}Si(OR⁵)_{4-c-d} (2)

   (wherein, R³ represents identical or different alkyl groups of 9 to 15 carbon atoms, R⁴ represents identical or different, unsubstituted or substituted monovalent hydrocarbon groups of 1 to 8 carbon atoms, R⁵ represents identical or different alkyl groups of 1 to 6 carbon atoms, c represents an integer from 1 to 3, and d represents an integer from 0 to 2, provided that c+d represents an integer from 1 to 3),
(D) an organohydrogenpolysiloxane containing 2 or more hydrogen atoms bonded to silicon atoms within each molecule, in sufficient quantity to provide from 0.1 to 5.0 hydrogen atoms bonded to silicon atoms within the component (D) for each alkenyl group within the component (A),
(E) 100 to 2,500 parts by volume of a heat conductive filler,
(F) an effective quantity of a platinum-based catalyst, and
(G) an effective quantity of an addition reaction retarder,
provided that the heat conductive filler consists of a heat conductive filler with an average particle size within a range from 0.01 to 50 µm.

A second aspect of the present invention provides a heat conductive silicone cured product, obtained by heating the above composition at 80 to 180°C to cure the composition.

A third aspect of the present invention provides an electronic device, comprising an electronic component, a heat-radiating member, and a heat conductive member comprising the above cured product which is disposed between the electronic component and the heat-radiating member.

A fourth aspect of the present invention provides a method of curing the above composition, comprising a step of heating the composition at 80 to 180°C.

A fifth aspect of the present invention provides a method of forming a heat conductive member between an electronic component and a heat-radiating member, comprising the steps of:
(I) applying the above composition to the surface of the electronic component,
(II) mounting the heat-radiating member on the applied composition, and
(III) subsequently heating the applied composition at 80 to 180°C to cure the composition.

A heat conductive silicone grease composition of the present invention has excellent thermal conductivity, and because it exhibits favorable fluidity prior to curing, also exhibits excellent workability during application to electronic components such as IC packages. Moreover, the composition is able to bond an electronic component and a heat-radiating member tightly together with no intervening gaps, even if the surfaces of the electronic component and the heat-radiating member contain fine irregularities, meaning the composition is able to significantly reduce the interfacial thermal resistance.

Furthermore, following curing by an addition reaction, the composition of the present invention will not contaminate components outside the region in which the composition was applied, which has been a problem with conventional heat conductive greases. Moreover, the composition does not suffer from bleeding of oily materials over time. Accordingly, the reliability of the semiconductor device can be further improved.

In addition, the heat conductive silicone grease composition of the present invention exhibits excellent durability under conditions of high temperature and high humidity, meaning it offers extremely favorable reliability when used for heat dissipation from general power sources or electronic equipment, or for heat dissipation from integrated circuit elements such as LSI and CPU used in all manner of electronic equipment including personal computers and digital video disc drives. Using a heat conductive silicone grease composition of the present invention enables dramatic improvements in the stability and lifespan of heat-generating electronic components and the electronic equipment that uses such components.

### BRIEF DESCRIPTION OF THE DRAWINGS

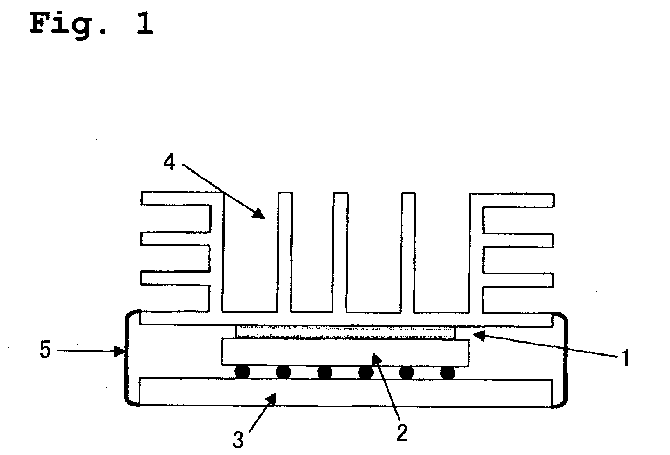

Fig. 1 is a schematic longitudinal cross-sectional view showing one example of a semiconductor device using a composition of the present invention.

### DETAILED DESCRIPTION OF THE PREFERRED EMBODIMENTS

A more detailed description of the present invention is presented below. In this description, quantities expressed using the units "parts by volume" and viscosity values all refer to values measured at 25°C.

### [Component (A)]

The component (A) of a composition of the present invention is an organopolysiloxane containing 2 or more alkenyl groups bonded to silicon atoms within each molecule, and is the primary component (the base polymer) within the addition reaction curing system of the present invention.

There are no particular restrictions on the molecular structure of the organopolysiloxane of the component (A), provided it is liquid at 25°C, and straight chains, branched chains, and straight chains with partial branching are all suitable, although straight-chain structures are particularly preferred.

The alkenyl groups typically contain from 2 to 10, and preferably from 2 to 6, carbon atoms. Examples of such alkenyl groups include a vinyl group, allyl group, 1-butenyl group, and 1-hexenyl group. Of these, a vinyl group, which is very flexible in terms of its use, is preferred. These alkenyl groups may be bonded to the silicon atoms at the molecular chain terminals of the organopolysiloxane, to silicon atoms within the molecular chain (that is, non-terminal silicon atoms), or to both these types of silicon atoms, although in order to ensure good flexibility of the resulting cured product, the alkenyl groups are preferably bonded only to silicon atoms at the molecular chain terminals.

Examples of other organic groups bonded to silicon atoms within the component (A), besides the aforementioned alkenyl groups, include unsubstituted or substituted monovalent hydrocarbon groups of 1 to 12, and preferably 1 to 10, carbon atoms. Specific examples of such groups include alkyl groups such as a methyl group, ethyl group, propyl group, butyl group, pentyl group, hexyl group, heptyl group, octyl group, nonyl group, decyl group or dodecyl group; cycloalkyl groups such as a cyclopentyl group or cyclohexyl group; aryl groups such as a phenyl group, tolyl group, xylyl group or naphthyl group; aralkyl groups such as a benzyl group, 2-phenylethyl group, or 2-phenylpropyl group; and halogenated alkyl groups such as a chloromethyl group, 3,3,3-trifluoropropyl group, or 3-chloropropyl group. From the viewpoints of ease of synthesis and economic viability, at least 90 mol%, and preferably 95 mol% or more of these non-alkenyl organic groups bonded to silicon atoms are preferably methyl groups.

The kinematic viscosity at 25°C of the organopolysiloxane of the component (A) is typically within a range from 50 to 100,000 mm²/s, and is preferably from 500 to 50,000 mm²/s. If this kinematic viscosity is too low, then the storage stability of the obtained composition may deteriorate, whereas if the kinematic viscosity is too high, then the extensibility of the obtained composition may worsen.

Examples of the organopolysiloxane of the component (A) include the compounds represented by a general formula (3) shown below: 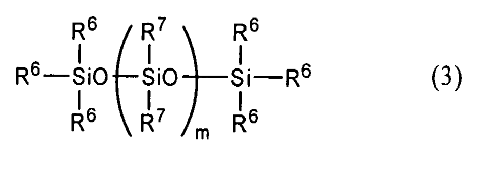 (wherein, R⁶ represents, identical or different, unsubstituted or substituted monovalent hydrocarbon groups, provided at least two of these R⁶ groups are alkenyl groups, R⁷ represents identical or different, unsubstituted or substituted monovalent hydrocarbon groups other than alkenyl groups, and m represents an integer of 1 or greater).

In the above general formula (3), the unsubstituted or substituted monovalent hydrocarbon groups represented by R⁶ typically contain from 1 to 12 carbon atoms, and specific examples include the alkenyl groups listed above, and those monovalent hydrocarbon groups listed above amongst the non-alkenyl organic groups bonded to silicon atoms. Examples of the unsubstituted or substituted monovalent hydrocarbon groups other than alkenyl groups represented by R⁷ include those monovalent hydrocarbon groups listed above amongst the non-alkenyl organic groups bonded to silicon atoms.

Furthermore, m is preferably an integer within a range from 50 to 3,000, and is even more preferably from 100 to 1,000.

Specific examples of preferred forms of the organopolysiloxane of the component (A) include dimethylpolysiloxane with both molecular chain terminals blocked with dimethylvinylsiloxy groups, dimethylpolysiloxane with both molecular chain terminals blocked with methyldivinylsiloxy groups, and copolymers of dimethylsiloxane and methylphenylsiloxane with both molecular chain terminals blocked with dimethylvinylsiloxy groups.

This organopolysiloxane of the component (A) may use either a single material, or a combination of two or more different materials (for example, two or more materials with different viscosities).

### [Component (B)]

The component (B) is an organopolysiloxane with a kinematic viscosity at 25°C within a range from 10 to 10,000 mm²/s, represented by a general formula (1) shown below: 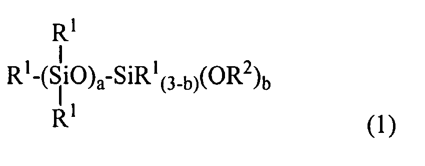 (wherein, R¹ represents identical or different, unsubstituted or substituted monovalent hydrocarbon groups, each R² represents, independently, an alkyl group, alkoxyalkyl group, alkenyl group or acyl group, a represents an integer from 5 to 100, and b represents an integer from 1 to 3).

The component (B) maintains the fluidity of the composition of the present invention, and imparts the composition with favorable handling properties, even when the composition is filled with a large quantity of the heat conductive filler of the component (E) in order to achieve a silicone grease composition with high thermal conductivity. The component (B) may use either a single compound, or a combination of two or more different compounds.

R¹ represents identical or different, unsubstituted or substituted monovalent hydrocarbon groups, and suitable examples include straight-chain alkyl groups, branched-chain alkyl groups, cyclic alkyl groups, alkenyl groups, aryl groups, aralkyl groups, and halogenated alkyl groups. Specific examples of suitable straight-chain alkyl groups include a methyl group, ethyl group, propyl group, hexyl group, or octyl group. Specific examples of suitable branched-chain alkyl groups include an isopropyl group, isobutyl group, tert-butyl group, or 2-ethylhexyl group. Specific examples of suitable cyclic alkyl groups include a cyclopentyl group or cyclohexyl group. Specific examples of suitable alkenyl groups include a vinyl group or allyl group. Specific examples of suitable aryl groups include a phenyl group or tolyl group. Specific examples of suitable aralkyl groups include a 2-phenylethyl group or 2-methyl-2-phenylethyl group. Specific examples of suitable halogenated alkyl groups include a 3,3,3-trifluoropropyl group, 2-(nonafluorobutyl)ethyl group, or 2-(heptadecafluorooctyl)ethyl group. R¹ is preferably a methyl group or a phenyl group.

Each R² represents, independently, an alkyl group, alkoxyalkyl group, alkenyl group or acyl group. Examples of suitable alkyl groups include the same straight-chain alkyl groups, branched-chain alkyl groups, and cyclic alkyl groups listed above in relation to R¹. Examples of suitable alkoxyalkyl groups include a methoxyethyl group or methoxypropyl group. Examples of suitable alkenyl groups include a vinyl group or allyl group. Examples of suitable acyl groups include an acetyl group or octanoyl group. R² is preferably an alkyl group, and a methyl group or ethyl group is particularly preferred.
a represents an integer from 5 to 100. b represents an integer from 1 to 3, and is preferably 3.

The kinematic viscosity of the component (B) at 25°C is typically within a range from 10 to 10,000 mm²/s, and is preferably from 10 to 5,000 mm²/s. If this kinematic viscosity is lower than 10 mm²/s, then the resulting silicone grease composition tends to be more prone to oil bleeding prior to curing. If the kinematic viscosity exceeds 10,000 mm²/s, then the fluidity and extensibility of the resulting silicone grease composition tend to be prone to deterioration.

The blend quantity of the component (B) is typically within a range from 0.1 to 300 parts by volume, and is preferably from 1 to 150 parts by volume, per 100 parts by volume of the component (A). If this blend quantity is too small, then the desired effects achieved by adding the component (B) may be unattainable. If the blend quantity is too large, then preventing oil separation and the bleeding of grease components from the cured product becomes more difficult, and moreover, the heat resistance and resistance to conditions of high temperature and high humidity tend to deteriorate.

Specific examples of preferred compounds of the component (B) include the compounds shown below.

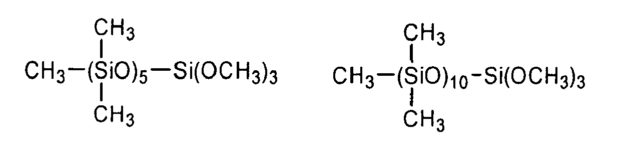

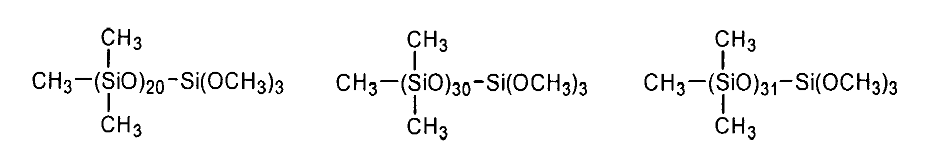

### [Component (C)]

The component (C) is an alkoxysilane represented by a general formula (2) shown below.

R³_{c}R⁴_{d}Si(OR⁵)_{4-c-d} (2)

(wherein, R³ represents identical or different alkyl groups of 9 to 15 carbon atoms, R⁴ represents identical or different, unsubstituted or substituted monovalent hydrocarbon groups of 1 to 8 carbon atoms, R⁵ represents identical or different alkyl groups of 1 to 6 carbon atoms, c represents an integer from 1 to 3, and d represents an integer from 0 to 2, provided that c+d represents an integer from 1 to 3)

The component (C) is a wetting component, and also prevents degradation of the component (B) under conditions of high temperature and high humidity. By treating the surface of the heat conductive filler of the component (E) with the component (C), the wetting characteristics between the component (E) and the component (B) can be improved. As a result, the component (C) assists in achieving high-quantity filling of the component (E). Furthermore, by using the component (C) in combination with the component (B), the component (C) is able to suppress contact between the component (B) and water vapor when the composition is used under conditions of high temperature and high humidity. As a result, the component (C) prevents degradation of the component (B) that is caused by hydrolysis under conditions of high temperature and high humidity, thereby preventing any deterioration in the performance of the heat conductive silicone grease composition of the present invention. The component (C) may use either a single compound, or a combination of two or more different compounds.

R³ represents identical or different alkyl groups of 9 to 15 carbon atoms, and specific examples of suitable groups include a nonyl group, decyl group, dodecyl group, tetradecyl group or pentadecyl group. If the number of carbon atoms is less than 9, then the wetting of the heat conductive filler (the component (E)) may be unsatisfactory, whereas if the number of carbon atoms exceeds 15, the component (C) becomes prone to solidification at room temperature, which not only makes the compound more difficult to handle, but also tends to reduce the thermal resistance and flame retardancy of the resulting composition.

R⁴ represents identical or different, unsubstituted or substituted, saturated or unsaturated monovalent hydrocarbon group of 1 to 8 carbon atoms, and specific examples of suitable groups include alkyl groups such as a methyl group, ethyl group, propyl group, hexyl group, or octyl group; cycloalkyl groups such as a cyclopentyl group or cyclohexyl group; alkenyl groups such as a vinyl group or allyl group; aryl groups such as a phenyl group or tolyl group; aralkyl groups such as a 2-phenylethyl group or 2-methyl-2-phenylethyl group; and halogenated hydrocarbon groups such as a 3,3,3-trifluoropropyl group, 2-(nonafluorobutyl)ethyl group, 2-(heptadecafluorooctyl)ethyl group, or p-chlorophenyl group. Of these, a methyl group or ethyl group is particularly preferred.

R⁵ represents identical or different alkyl groups of 1 to 6 carbon atoms, and specific examples of suitable groups include a methyl group, ethyl group, propyl group, butyl group, pentyl group, or hexyl group. A methyl group or ethyl group is particularly preferred.

c typically represents an integer from 1 to 3, but is most preferably l. d represents an integer from 0 to 2. The value of c+d is an integer from 1 to 3.

Specific examples of the component (C) include the compounds shown below.

C₁₀H₂₁Si(OCH₃)₃

C₁₂H₂₅Si(OCH₃)₃

C₁₂H₂₅Si(OC₂H₅)₃

C₁₀H₂₁Si(CH₃)(OCH₃)₂

C₁₀H₂₁ Si(C₆H₅)(OCH₃)₂

C₁₀H₂₁Si(CH₃)(OC₂H₅)₂

C₁₀H₂₁Si(CH=CH₂)(OCH₃)₂

C₁₀H₂₁Si(CH₂CH₂CF₃)(OCH₃)₂

The quantity added of the component (C) is typically within a range from 0.1 to 50 parts by volume, and is preferably from 1 to 20 parts by volume, per 100 parts by volume of the component (A). If the quantity added falls within this range, then the wetting effect and the resistance to high temperature and high humidity can be easily increased by increasing the addition quantity, which ensures good economic viability. On the other hand, because the component (C) is slightly volatile, if a heat conductive silicone grease composition comprising the component (C) is left standing in an open system, then the component (C) may evaporate, causing the composition to gradually harden. However, if the addition quantity is kept within the above range, this type of hardening phenomenon can be more readily prevented.

### [Component (D)]

The component (D) of a composition of the present invention is an organohydrogenpolysiloxane containing 2 or more, and preferably from 2 to 100, hydrogen atoms bonded to silicon atoms (hereafter also referred to as "SiH groups") within each molecule, which functions as a cross-linking agent for the component (A). In other words, under the action of the platinum-based catalyst of the component (F) described below, the SiH groups within the component (D) undergo addition via a hydrosilylation reaction to the alkenyl groups of the component (A), thereby forming a cross-linked cured product comprising a three dimensional network structure containing cross-linked bonds.

Examples of organic groups that are bonded to silicon atoms within the component (D) include unsubstituted or substituted monovalent hydrocarbon groups other than alkenyl groups, and specific examples include the same groups as the non-alkenyl organic groups bonded to silicon atoms described above in relation to the component (A). Of these groups, from the viewpoints of ease of synthesis and economic viability, methyl groups are preferred.

There are no particular restrictions on the structure of the organohydrogenpolysiloxane of the component (D), and straight-chain, branched-chain and cyclic structures are all suitable, although straight-chain structures are particularly preferred.

Examples of the organohydrogenpolysiloxane of the component (D) include compounds represented by a general formula (4) shown below: 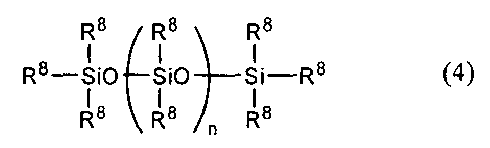 (wherein, each R⁸ represents, independently, an unsubstituted or substituted monovalent hydrocarbon group other than an alkenyl group, or a hydrogen atom, provided that at least two of these R⁸ groups are hydrogen atoms, and n represents an integer of 1 or greater).

In the above general formula (4), examples of the unsubstituted or substituted monovalent hydrocarbon groups other than alkenyl groups represented by R⁸ include those monovalent hydrocarbon groups listed above amongst the non-alkenyl organic groups bonded to silicon atoms described in relation to the component (A).

Furthermore, n is preferably an integer within a range from 2 to 100, and is even more preferably from 5 to 50.

Specific examples of preferred organohydrogenpolysiloxanes for the component (D) include methylhydrogenpolysiloxane with both molecular chain terminals blocked with trimethylsiloxy groups, copolymers of dimethylsiloxane and methylhydrogensiloxane with both molecular chain terminals blocked with trimethylsiloxy groups, copolymers of dimethylsiloxane, methylhydrogensiloxane and methylphenylsiloxane with both molecular chain terminals blocked with trimethylsiloxy groups, dimethylpolysiloxane with both molecular chain terminals blocked with dimethylhydrogensiloxy groups, copolymers of dimethylsiloxane and methylhydrogensiloxane with both molecular chain terminals blocked with dimethylhydrogensiloxy groups, copolymers of dimethylsiloxane and methylphenylsiloxane with both molecular chain terminals blocked with dimethylhydrogensiloxy groups, and methylphenylpolysiloxane with both molecular chain terminals blocked with dimethylhydrogensiloxy groups. Furthermore, the organohydrogenpolysiloxane of the component (D) may use either a single material, or a combination of two or more different materials.

The blend quantity of the component (D) is sufficient to provide from 0.1 to 5.0, and preferably from 0.5 to 3.0, hydrogen atoms bonded to silicon atoms within this component for each alkenyl group within the component (A). If this number is less than 0.1, then a satisfactory three dimensional network structure is not formed, meaning the required level of hardness is not achieved following curing, and also increasing the likelihood that the heat conductive filler described below will be unable to be fixed and supported within the cured product. In contrast, if the number exceeds 5.0, then the variation over time in the physical properties of the resulting cured product tends to increase, and the storage stability may deteriorate.

### [Component (E)]

The component (E) functions as a heat conductive filler within the heat conductive silicone grease composition of the present invention. The component (E) may use either a single compound, or a combination of two or more different compounds.

The average particle size of the component (E) is typically within a range from 0.01 to 50 µm, preferably from 0.1 to 50 µm, more preferably from 0.1 to 35 µm, and even more preferably from 0.5 to 35 µm. Within the heat conductive silicone grease composition of the present invention, the above heat conductive filler consists of a heat conductive filler with an average particle size within the above range. Provided the average particle size falls within this range, the bulk density of the component (E) can be easily increased, and the specific surface area can be easily reduced, meaning high-quantity filling of the component (E) within the heat conductive silicone grease composition of the present invention can be achieved more easily. If the average particle size is too large, then oil separation may proceed more readily. In the present invention, the average particle size can be determined by using a laser diffraction method to determine a volume-based cumulative average particle size.

There are no particular restrictions on the shape of the particles of the component (E), and spherical, rod-shaped, needle-like, disc-shaped, and irregularly shaped particles are all suitable.

Specific examples of the component (E) include aluminum, silver, copper, nickel, zinc oxide, alumina, magnesium oxide, aluminum nitride, boron nitride, silicon nitride, diamond, graphite, carbon nanotubes, metallic silicon, carbon fiber, fullerene, or combinations of two or more of these materials.

The quantity added of the component (E) is typically within a range from 100 to 2,500 parts by volume, and is preferably from 150 to 2,000 parts by volume, per 100 parts by volume of the component (A). If this addition quantity is less than 100 parts by volume, then the thermal conductivity of the resulting heat-radiating member tends to decrease. In contrast, if the total quantity added exceeds 2,500 parts by volume, then the viscosity of the resulting composition tends to become overly high, making the fluidity and handling characteristics of the composition unsatisfactory.

### [Component (F)]

The platinum-based catalyst of the component (F) of a composition of the present invention accelerates the addition reaction between the alkenyl groups within the component (A) and the SiH groups within the component (D), and is added to promote the formation of a cross-linked cured product with a three dimensional network structure from the composition of the present invention.

Any of the catalysts typically used in conventional hydrosilylation reactions can be used as this component (F). Specific examples of the component (D) include platinum metal (platinum black), chloroplatinic acid, platinum-olefin complexes, platinum-alcohol complexes, platinum-vinyl group containing organopolysiloxane complexes, and platinum coordination compounds. The platinum-based catalyst of the component (F) may use either a single material, or a combination of two or more different materials.

There are no particular restrictions on the blend quantity of the component (F), which need only be an effective catalytic quantity required to cure the composition of the present invention, although a typical quantity, calculated as the mass of platinum atoms relative to the mass of the oil components (namely, the combination of the component (A), the component (B), the component (C), the component (D), the component (F), the component (G), and where used the component (H)), is within a range from 200 to 5,000 ppm.

### [Component (G)]

The addition reaction retarder of the component (G) of a composition of the present invention inhibits the hydrosilylation reaction caused by the action of the platinum-based catalyst from occurring at room temperature, thus enhancing the usable life (the shelf life or pot life) of the composition, and is added to ensure that no problems arise during the application of the composition to an electronic component or the like.

Any of the conventional addition reaction retarders used in typical addition reaction-curable silicone compositions can be used as this component (G). Specific examples include acetylene compounds such as 1-ethynyl-1-cyclohexanol and 3-butyn-1-ol, as well as a variety of nitrogen compounds, organophosphorus compounds, oxime compounds, and organochlorine compounds. The addition reaction retarder of the component (G) may use either a single material, or a combination of two or more different materials.

The blend quantity of this component (G) cannot be generalized, and varies depending on the quantity used of the component (F), although any quantity that is effective in inhibiting the progression of the hydrosilylation reaction can be used, and typically, a quantity within a range from 1,000 to 10,000 ppm relative to the mass of the oil components is suitable. If the blend quantity of the component (G) is too small, then a satisfactory usable life cannot be ensured, whereas if the quantity is too large, the curability of the composition may deteriorate.

In order to improve the dispersibility within the composition, where required, this component (G) may be diluted with an organic solvent such as toluene, xylene or isopropyl alcohol prior to use.

### [Component (H)]

A composition of the present invention may also include, as an optional component, an organopolysiloxane with a kinematic velocity at 25°C of 10 to 100,000 mm²/s, represented by an average composition formula (5) shown below:

R⁹ₑSiO(₄₋ₑ)_{/2} (5)

(wherein, R⁹ represents identical or different, unsubstituted or substituted monovalent hydrocarbon groups of 1 to 18 carbon atoms, and e represents a number from 1.8 to 2.2).

The component (H) can be used for imparting certain desired properties to the heat conductive silicone grease composition of the present invention, and can function as a viscosity-regulating agent or an adhesion-imparting agent or the like, although the component (H) is not limited to such uses. The component (H) may use either a single compound, or a combination of two or more different compounds.

R⁹ represents identical or different, unsubstituted or substituted monovalent hydrocarbon group of 1 to 18 carbon atoms. Specific examples of suitable R⁹ groups include alkyl groups such as a methyl group, ethyl group, propyl group, hexyl group, octyl group, decyl group, dodecyl group, tetradecyl group, hexadecyl group, or octadecyl group; cycloalkyl groups such as a cyclopentyl group or cyclohexyl group; alkenyl groups such as a vinyl group or allyl group; aryl groups such as a phenyl group or tolyl group; aralkyl groups such as a 2-phenylethyl group or 2-methyl-2-phenylethyl group; and halogenated hydrocarbon groups such as a 3,3,3-trifluoropropyl group, 2-(perfluorobutyl)ethyl group, 2-(perfluorooctyl)ethyl group, or p-chlorophenyl group. Of these, a methyl group, phenyl group, or alkyl group of 6 to 18 carbon atoms is particularly preferred.

From the viewpoint of ensuring that the composition of the present invention has the consistency required to function as a silicone grease composition, e preferably represents a number within a range from 1.8 to 2.2, and is even more preferably a number from 1.9 to 2.1.

Furthermore, the kinematic viscosity of the component (H) at 25°C is typically within a range from 10 to 100,000 mm²/s, and is preferably from 10 to 10,000 mm²/s. If this kinematic viscosity is lower than 10 mm²/s, then the resulting silicone grease composition tends to be more prone to oil bleeding. If the kinematic viscosity exceeds 100,000 mm²/s, then the fluidity of the resulting silicone grease composition tends to deteriorate.

Specific examples of the component (H) include the compounds shown below.

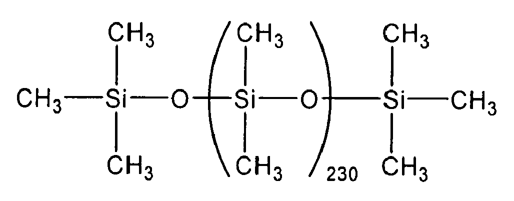

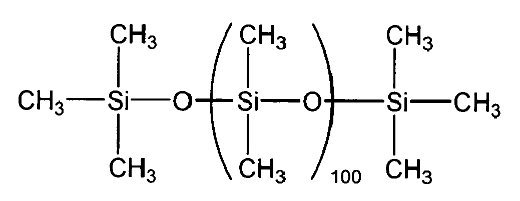

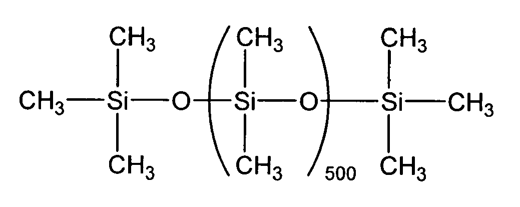

When a component (H) is added to a composition of the present invention, there are no particular restrictions on the quantity added, and any quantity that yields the desired effect is suitable, although the quantity added is preferably not more than 200 parts by volume, and is even more preferably 100 parts by volume or less, per 100 parts by volume of the component (A). If the addition quantity is within this range, then the extremely favorable fluidity and workability of the composition of the present invention can be more easily maintained, and a large quantity of the heat conductive filler of the component (E) can be more easily included within the composition.

### [Other Additives]

Typically used additives or fillers may also be added, as optional components, to a heat conductive silicone grease composition of the present invention, provided the addition of these optional components does not impair the purpose of the present invention. Specific examples of these optional components include fluorine-modified silicone surfactants; colorants such as carbon black, titanium dioxide, and red iron oxide; flame retardancy-imparting agents such as platinum catalysts, metal oxides such as iron oxide, titanium oxide and cerium oxide, and metal hydroxides. Moreover, in order to prevent sedimentation of the heat conductive filler under high temperature conditions, a finely powdered silica such as a precipitated silica or calcined silica, or a thixotropic improvement agent or the like may also be added.

### [Viscosity]

A composition of the present invention exists in a grease form (which also includes pastes) at room temperature (25°C). As a result, a composition of the present invention exhibits favorable workability during operations such as application to the surface of an electronic component.

A composition of the present invention can be used, for example, to fill a syringe. Specifically, the composition may be used to fill a syringe, the composition may then be discharged from this syringe and onto the surface of an electronic component such as a CPU or the like to form a coating layer, and a heat-radiating member may then be pressed onto this coating layer. Application of the composition of the present invention may be conducted by screen printing. Such screen printing may be conducted using a metal mask or a screen mesh or the like. Accordingly, the viscosity at 25°C of the composition of the present invention is preferably not higher than 500 Pa·s (from 1 to 500 Pa·s), and is even more preferably 300 Pa·s or less (10 to 300 Pa·s). If the viscosity is within this range, then the composition tends to be more resistant to overrun and tends to have more favorable fluidity, which improves the workability properties such as the dispensing and screen printing characteristics, and makes it easier to apply a thin coating of the composition to a substrate. Moreover, if a syringe is used for applying the composition, then a viscosity within the above range enables the composition to be more readily dispensed from the syringe.

### [Preparation of a Composition of the Present Invention]

A heat conductive silicone grease composition of the present invention can be obtained by a preparation method that comprises the steps of:
(a) kneading together the component (A), the component (B), the component (C), the component (E), and where used the component (H), preferably at a temperature within a range from 40 to 120°C, and even more preferably from 50 to 100°C, thereby generating a uniform mixture, and
(b) adding the component (D), the component (F), the component (G), and where used any other optional components to the uniform mixture, and then conducting kneading, preferably at a temperature within a range from 10 to 60°C, and even more preferably from 20 to 50°C, thereby generating a uniform mixture.

In the above steps, kneading can be conducted using a mixing-kneading device such as a conditioning mixer or planetary mixer, which is fitted with a heating device and may also include a cooling device if required.

The step (b) is preferably completed as quickly as possible in order to prevent the components (A), (D), (F) and (G) from reacting together over time and altering the makeup of the composition. Generally, following completion of the step (b), the resulting composition is placed in a container and then stored immediately within a freezer or refrigerated room at a temperature within a range from approximately -30 to - 10°C, and preferably from -25 to -15°C. When the composition needs to be transported, a vehicle fitted with refrigeration equipment should be used. By storing and transporting the composition under low temperature conditions in this manner, the makeup and dispersive state of the composition of the present invention can be stably maintained even upon extended storage.

### [Method of Curing]

A composition of the present invention can be cured by heating the composition to form a cured product. This curing is preferably conducted at a temperature within a range from 80 to 180°C, and even more preferably from 100 to 150°C. This cured product can be used, for example, as a heat conductive member such as a thin heat conductive layer for effecting the radiation of heat from an electronic component.

Moreover, by employing a method of curing that includes a step of heating the composition at a temperature of 80 to 180°C while pressure is applied, the cured product can be obtained in the form of a favorably thin layer (for example, with a thickness of 5 to 100 µm). The pressure can be applied, for example, by using a method in which the composition is sandwiched between metal plates of aluminum, nickel or copper or the like, and pressure is then applied using a clip or the like, although there are no particular restrictions on the method employed. Furthermore, the pressure applied is typically within a range from 50 to 1,500 kPa, and is preferably from 100 to 700 kPa.

### [Thermal Resistance]

Furthermore, the thermal resistance at 25°C of a heat conductive silicone grease composition of the present invention and a cured product thereof, measured using a laser flash method, is preferably not more than 10 mm²·K/W, and is even more preferably 6 mm²·K/W or less. If the thermal resistance is within this range, then the composition and cured product of the present invention are able to efficiently dissipate the heat generated by an electronic component into a heat-radiating component, even in those cases where the electronic component has a large heat value. Measurement of the thermal resistance using a laser flash method can be conducted in accordance with ASTME 1461.

### [Electronic Device]

A composition of the present invention can be used for producing an electronic device such as a semiconductor device with excellent heat-radiating characteristics, namely, an electronic device comprising an electronic component such as a heat-generating electronic component (for example, an integrated circuit element such as a LSI or CPU), a heat-radiating member such as a heat-radiating component (for example, a heat spreader or heat sink), a heat pipe or a heat sink, and a heat conductive member comprising a cured product of a composition of the present invention, which is provided between the electronic component and the heat-radiating member. The thickness of the heat conductive member is preferably within a range from 5 to 100 µm, and even more preferably from 10 to 30 µm. In order to produce this electronic device, the heat conductive member is preferably generated between the electronic component and the heat-radiating member using a method of forming the heat conductive member that comprises the steps of:
(I) applying the composition to the surface of the electronic component,
(II) mounting the heat-radiating member on the applied composition, and
(III) subsequently heating the applied composition at a temperature from 80 to 180°C, and even more preferably from 100 to 150°C to cure the composition. By providing the heat conductive member between the electronic component and the heat-radiating member, heat can be transmitted efficiently from the electronic component into the heat-radiating member, meaning the heat can be effectively dissipated away from the electronic component.

### <Sample Electronic Device>

An electronic device and a method of producing the device are described below with reference to Fig. 1, which is a schematic longitudinal cross-sectional view showing a semiconductor device as one example of the electronic device. The device shown in Fig. 1 is merely one example of the application of a composition of the present invention to a semiconductor device, and an electronic device according to the present invention is in no way restricted by the device shown in Fig. 1.

As shown in Fig. 1, this semiconductor device comprises an IC package 2 such as a CPU mounted on top of a printed wiring board 3, and a heat conductive member 1 produced by curing a heat conductive silicone grease composition disposed between the IC package 2 and a heat-radiating member 4. The heat-radiating member 4 has fins in order to increase the surface area and improve the heat-radiating effect. Furthermore, the heat-radiating member 4 and the printed wiring board 3 are held together under pressure by a clamp 5.

A method of producing this semiconductor device is described below.

First, the composition is used to fill an application tool such as a syringe. In those cases where the composition has been stored in a frozen state, the composition is placed at room temperature and allowed to thaw naturally to a grease-like state prior to use.

The composition is then discharged from the syringe or the like, and applied (dispensed) onto the surface of the IC package 2 mounted on top of the printed wiring board 3, thus forming a composition layer 1. The heat-radiating member 4 is then mounted on top of the composition layer 1, and the clamp 5 is used to pressure-bond and secure the heat-radiating member 4 to the IC package 2 via the composition layer 1.

During this process, the clamp 5 is preferably adjusted so that the thickness of the composition layer 1 sandwiched between the IC package 2 and the heat-radiating member 4 is typically within a range from 5 to 100 µm, and preferably from 10 to 30 µm. If the composition layer is overly thin, then the composition of the present invention may be unable to satisfactorily conform to the surfaces of the IC package 2 and the heat-radiating member 4 during the pressure-bonding described above, meaning there is a danger of gaps appearing between the IC package 2 and the heat-radiating member 4. In contrast, if the composition layer is overly thick, then the thermal resistance increases, meaning a satisfactory heat-radiating effect may be unattainable.

Subsequently, the device is passed, in this pressurized state, through a heating device such as a reflow oven, thereby curing the composition layer 1 and forming the heat conductive member 1. The temperature conditions required during this curing step are typically within a range from 80 to 180°C, and preferably from 100 to 150°C. If this curing temperature is less than 80°C, then the curing may be inadequate, whereas if the curing temperature exceeds 180°C, there is a danger of degradation of the electronic component or the substrate.

During operation or use of an electronic device such as a semiconductor device produced in this manner, the surface temperature of the electronic component such as an IC package typically reaches a temperature of approximately 60 to 120°C. The heat conductive member comprising the cured product of the composition of the present invention displays excellent thermal conductivity of this generated heat, and produces heat-radiating characteristics that are markedly superior to those of conventional heat conductive sheets or heat conductive greases. Moreover, even when the electronic device such as a semiconductor device is operated or used continuously over extended periods, because the oil components are fixed and supported within the three dimensional cross-linked network structure of the cured product, no leakage occurs from the heat conductive member.

Moreover the heat conductive member also exhibits tackiness, so that even if the heat-radiating member is slightly offset, or even after extended usage, the conductive member maintains a stable level of flexibility, and is unlikely to separate from either the electronic component or the heat-radiating member.

Similar effects can also be achieved by preparing in advance a sheet-like cured product of a desired thickness using a composition of the present invention, and then sandwiching this sheet between an electronic component and a heat-radiating member in a similar manner to a conventional heat conductive sheet. In addition, a cured sheet or the like of a composition of the present invention can also be used as a component within other devices that require favorable thermal conductivity and heat resistance.

### EXAMPLES

As follows is a more detailed description of the present invention using a series of examples and comparative examples, although the present invention is in no way limited by these examples.

First, the following components required for forming compositions of the present invention were prepared.

### <Component (A)>

- (A-1) A dimethylpolysiloxane with both molecular chain terminals blocked with dimethylvinylsiloxy groups, and with a kinematic viscosity at 25°C of 600 mm²/s.
- (A-2) A dimethylpolysiloxane with both molecular chain terminals blocked with dimethylvinylsiloxy groups, and with a kinematic viscosity at 25°C of 30,000 mm²/s.

### <Component (B)>

- (B-1) An organopolysiloxane (with a kinematic viscosity at 25°C of 35 mm²/s), represented by a formula shown below.

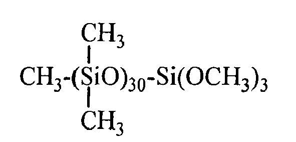

### <Component (C)>

- (C-1) An alkoxysilane represented by the formula below.

   C₁₀H₂₁Si(OCH₃)₃
- (C-2) An alkoxysilane represented by the formula below.

   C₁₂H₂₅Si(OC₂H₅)₃

### <Component (D)>

- (D-1) An organohydrogenpolysiloxane represented by a structural formula shown below.

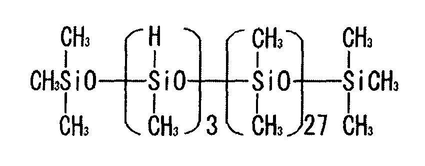

### <Component (E)>

- (E-1) Aluminum powder (average particle size: 10.7 µm, fraction that passed through a mesh size of 32 µm prescribed in JIS Z 8801-1).
- (E-2) Alumina powder (average particle size: 10.2 µm, the fraction that passed through a mesh size of 32 µm prescribed in JIS Z 8801-1).
- (E-3) Aluminum powder (average particle size: 1.5 µm, the fraction that passed through a mesh size of 32 µm prescribed in JIS Z 8801-1).
- (E-4) Alumina powder (average particle size: 1.2 µm, the fraction that passed through a mesh size of 32 µm prescribed in JIS Z 8801-1).
- (E-5) Zinc oxide powder (average particle size: 1.0 µm, the fraction that passed through a mesh size of 32 µm prescribed in JIS Z 8801-1).
- (E-6) Alumina powder (average particle size: 103 µm, unclassified).

The average particle size values listed above for the various components (E) represent volume-based cumulative average particle size values measured using a particle size analyzer (Microtrac MT3300EX, manufactured by Nikkiso Co., Ltd.).

### <Component (F)>

- (F-1) A dimethylpolysiloxane (with both molecular chain terminals blocked with dimethylvinylsilyl groups) solution of a platinum-divinyltetramethyldisiloxane complex [platinum atom content: 1% by mass].

### <Component (G)>

- (G-1) A 50% by mass toluene solution of 1-ethynyl-1-cyclohexanol.

### <Component (H)>

- (H-1) An organohydrogenpolysiloxane with a kinematic viscosity of 500 mm²/s, represented by a formula shown below.

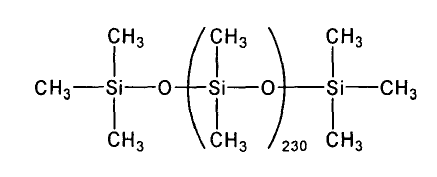

### <Preparation of Compositions>

Using the compounds and blend quantities shown in Table 1 and Table 2, compositions were prepared in the manner described below.

In a planetary mixer with an internal capacity of 700 ml (product name: T.K. Hivis Mix, manufactured by Tokushu Kika Kogyo Co., Ltd.) were placed the component (A), the component (B), the component (C), the component (E), and where used the component (H), and the temperature was then raised to 80°C and held at that temperature while mixing was conducted for 60 minutes. Subsequently, the mixing was halted and the temperature was cooled to 25°C. The component (D), the component (F), and the component (G) were then added, and mixing was conducted to prepare a uniform composition.

### [Test Methods]

The properties of the prepared compositions were measured using the test methods described below. The results are shown in Table 1 and Table 2.

### [Measurement of Viscosity]

Each of the prepared compositions was allowed to stand for 3 hours in a constant-temperature chamber at 25°C, and the viscosity was then measured at a rotational velocity of 10 rpm using a viscometer (product name: Spiral Viscometer PC-1TL, manufactured by Malcom Co., Ltd.).

### [Measurement of Thermal Conductivity]

Each of the prepared compositions was poured into a mold with a thickness of 3 cm, a kitchen wrap was used to cover the composition, and the thermal conductivity of the composition was then measured using a thermal conductivity meter (product name: QTM-500) manufactured by Kyoto Electronics Manufacturing Co., Ltd.

### [Preparation of Cured Products]

0.2 g of each composition obtained above (excluding those of the comparative example 1 and the comparative example 2) was applied across the entire surface of a standard circular aluminum plate (diameter: approximately 12.7 mm, thickness: approximately 1.0 mm), another standard aluminum plate was placed on top, and the resulting structure was then squeezed together with a clip under a pressure of approximately 175.5 kPa (1.80 kgf/cm²), thereby forming a 3-layer structure. This 3-layer structure was then placed inside an electric oven, with the pressure from the clip still applied, and the temperature was raised to 125°C. This temperature was maintained for 90 minutes to cure the composition, and the structure was then left to cool to room temperature, thus completing the preparation of a test piece for the measurement of thermal resistance.

### [Measurement of Thickness]

The thickness of each test piece was measured using a micrometer (model: M820-25VA, manufactured by Mitutoyo Corporation), and the thickness of the cured product was then calculated by subtracting the known thickness of the two aluminum plates.

### [Measurement of Thermal Resistance]

For each of the test pieces described above, the thermal resistance (units: mm²·K/W) of the cured product was measured at 25°C, using a thermal resistance measurement device that employed a laser flash method (LFA447 NanoFlash, a xenon flash analyzer manufactured by Netzch Group).

### [Measurement of Thermal Resistance after standing under conditions of High Temperature and High Humidity]

Following the above measurement of the thermal resistance, each test piece was left to stand for 192 hours in an atmosphere at 130°C / 85% RH, and the thermal resistance (units: mm²·K/W) of the cured product was then re-measured using the same thermal resistance measurement device as above.

### [Application to Semiconductor Devices]

0.2 g of each composition from the examples 1 to 5 was applied to the surface of a 2 cm x 2 cm CPU to form a composition layer. A heat-radiating member was then overlaid and pressure-bonded to the composition layer, and with the structure held under pressure, the composition was cured by heating in the same manner as that described above in the section entitled "Preparation of Cured Products", thus yielding a semiconductor device in which the CPU and the heat-radiating member were bonded together via a heat conductive member with a thickness of 10 to 30 µm. Each of the produced devices was installed in a host computer or a personal computer or the like and operated, and even though the output temperature of the CPU was approximately 100°C, all of the devices were able to be used over an extended period, with stable thermal conductivity and heat radiation, and potential problems such as deterioration in the CPU performance or device failure caused by excessive heat accumulation were able to be prevented. Accordingly, it was confirmed that employing a cured product of a composition of the present invention enables an improvement in the reliability of a semiconductor device.

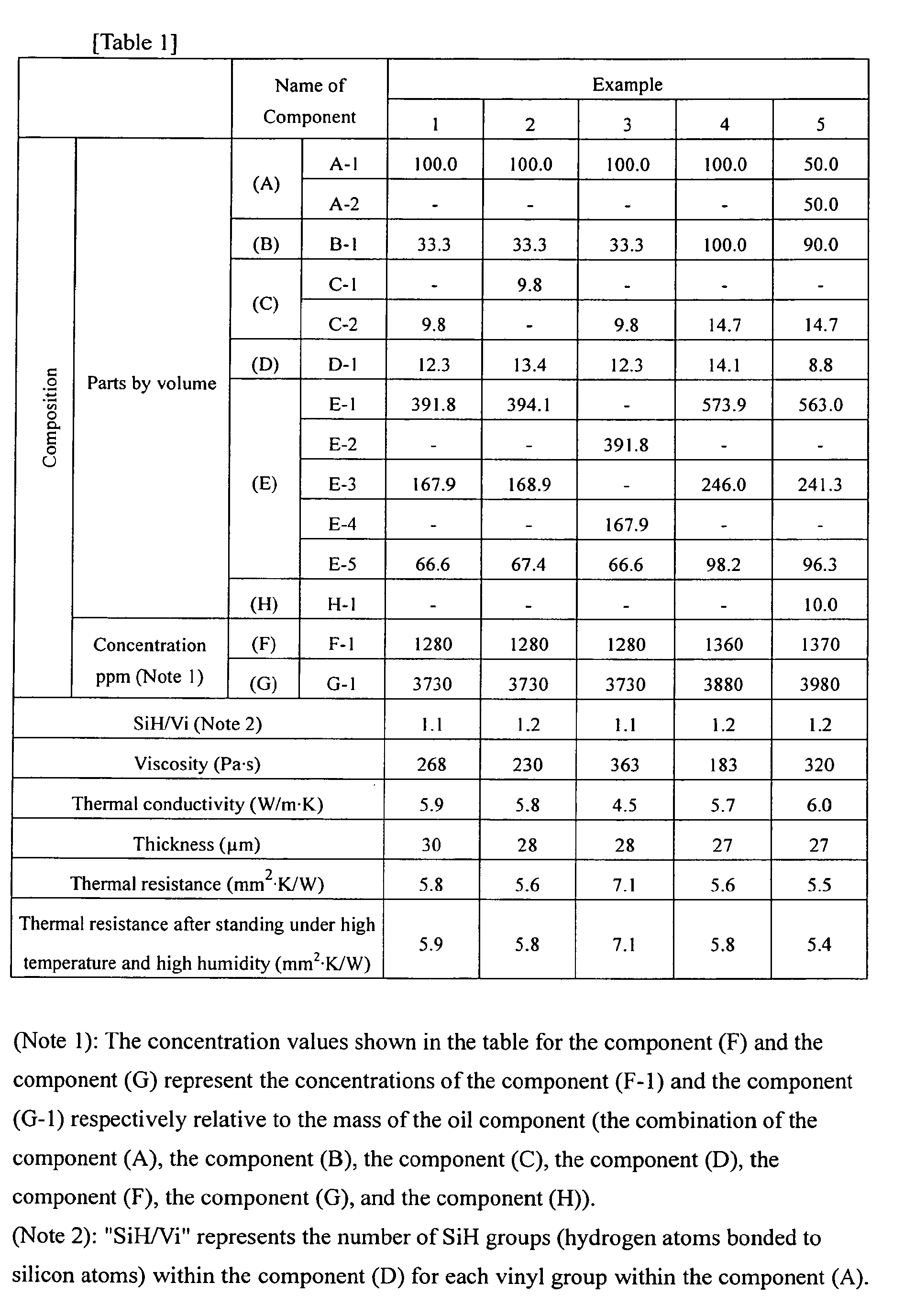

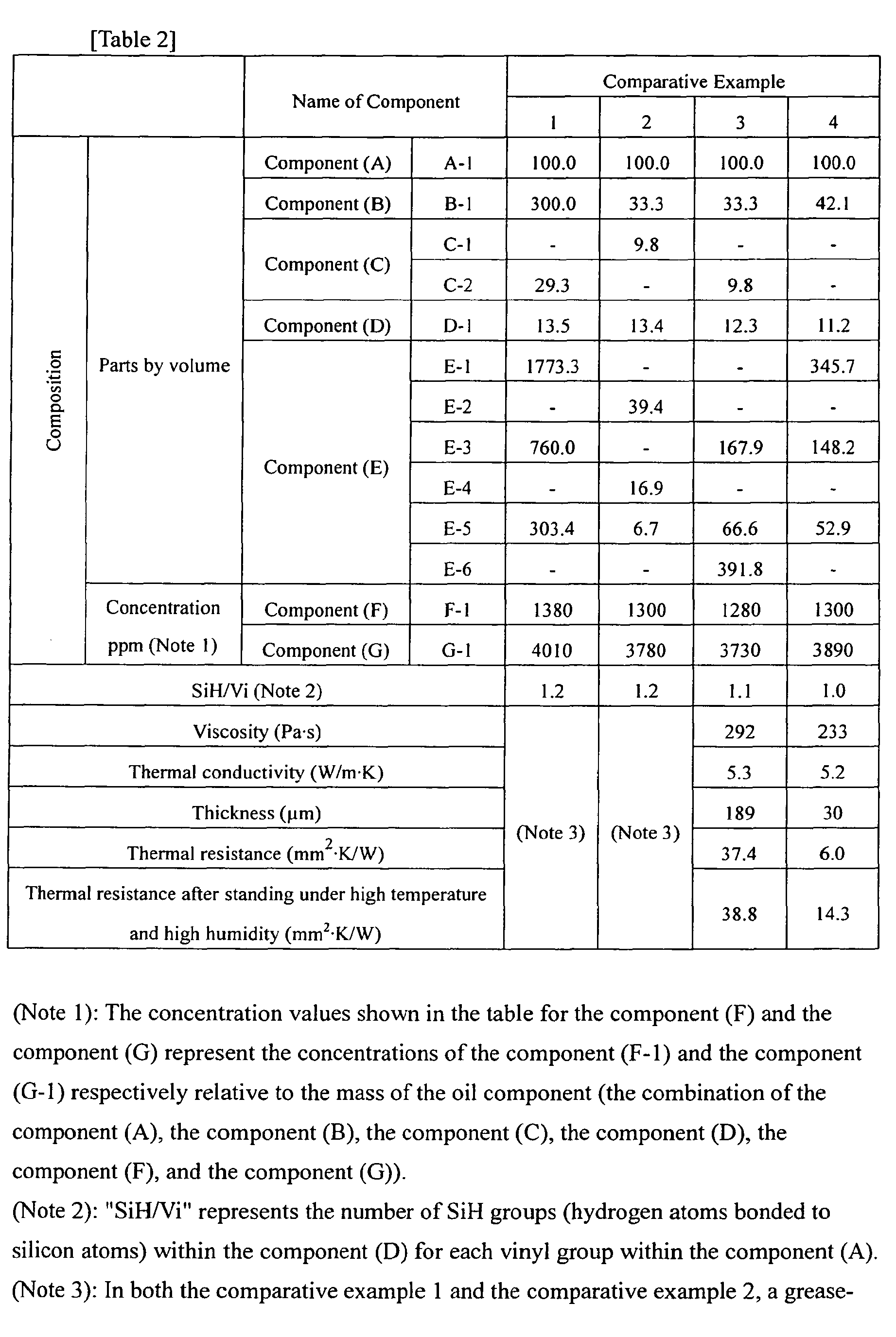

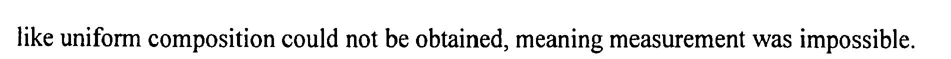

## Claims

1. A heat conductive silicone grease composition, comprising:
(A) 100 parts by volume of an organopolysiloxane containing 2 or more alkenyl groups bonded to silicon atoms within each molecule,
(B) 0.1 to 300 parts by volume of an organopolysiloxane with a kinematic viscosity at 25°C within a range from 10 to 10,000 mm²/s, represented by a general formula (1) shown below: 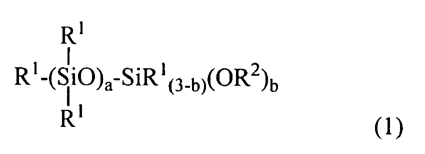 (wherein, R¹ represents identical or different, unsubstituted or substituted monovalent hydrocarbon groups, each R² represents, independently, an alkyl group, alkoxyalkyl group, alkenyl group or acyl group, a represents an integer from 5 to 100, and b represents an integer from 1 to 3),
(C) 0.1 to 50 parts by volume of an alkoxysilane represented by a general formula (2) shown below:
R³_{c}R⁴_{d}Si(OR⁵)_{4-c-d} (2)
(wherein, R³ represents identical or different alkyl groups of 9 to 15 carbon atoms, R⁴ represents identical or different, unsubstituted or substituted monovalent hydrocarbon groups of 1 to 8 carbon atoms, R⁵ represents identical or different alkyl groups of 1 to 6 carbon atoms, c represents an integer from 1 to 3, and d represents an integer from 0 to 2, provided that c+d represents an integer from 1 to 3),
(D) an organohydrogenpolysiloxane containing 2 or more hydrogen atoms bonded to silicon atoms within each molecule, in sufficient quantity to provide from 0.1 to 5.0 hydrogen atoms bonded to silicon atoms within said component (D) for each alkenyl group within said component (A),
(E) 100 to 2,500 parts by volume of a heat conductive filler,
(F) an effective quantity of a platinum-based catalyst, and
(G) an effective quantity of an addition reaction retarder,
provided that said heat conductive filler consists of a heat conductive filler with an average particle size within a range from 0.01 to 50 µm.

2. The composition according to claim 1, wherein said component (C) is C₁₀H₂₁Si(OCH₃)₃, C₁₂H₂₅Si(OCH₃)₃, C₁₂H₂₅Si(OC₂H₅)₃, C₁₀H₂₁Si(CH₃)(OCH₃)₂, C₁₀H₂₁Si(C₆H₅)(OCH₃)₂, C₁₀H₂₁Si(CH₃)(OC₂H₅)₂, C₁₀H₂₁Si(CH=CH₂)(OCH₃)₂, C₁₀H₂₁Si(CH₂CH₂CF₃)(OCH₃)₂, or a combination thereof.

3. The composition according to claim 1, wherein said component (E) is aluminum, silver, copper, nickel, zinc oxide, alumina, magnesium oxide, aluminum nitride, boron nitride, silicon nitride, diamond, graphite, carbon nanotubes, metallic silicon, carbon fiber, fullerene, or a combination thereof.

4. The composition according to claim 1, further comprising:
(H) an organopolysiloxane with a kinematic velocity at 25°C within a range from 10 to 100,000 mm²/s, represented by an average composition formula (5) shown below:
R⁹ₑSiO_{(4-e)/2} (5)
(wherein, R⁹ represents identical or different, unsubstituted or substituted monovalent hydrocarbon groups of 1 to 18 carbon atoms, and e represents a number from 1.8 to 2.2).

5. The composition according to claim 1, wherein a viscosity of said composition at 25°C is not greater than 500 Pa·s.

6. A heat conductive silicone cured product, obtained by heating the composition defined in claim 1 at 80 to 180°C to cure said composition.

7. The cured product according to claim 6, wherein a thermal resistance of said cured product at 25°C, measured using a laser flash method, is not greater than 10 mm²·K/W.

8. An electronic device, comprising an electronic component, a heat-radiating member, and a heat conductive member comprising the cured product defined in claim 5, which is disposed between said electronic component and said heat-radiating member.

9. The electronic device according to claim 8, wherein the thickness of said heat conductive member is within a range from 5 to 100 µm.

10. A method of curing the composition defined in claim 1, comprising a step of heating said composition at 80 to 180°C.

11. A method of forming a heat conductive member between an electronic component and a heat-radiating member, comprising the steps of:
(I) applying the composition defined in claim 1 to a surface of said electronic component,
(II) mounting said heat-radiating member on said applied composition, and
(III) subsequently heating said applied composition at 80 to 180°C to cure said composition.
